Europäisches Patentamt

European Patent Office

Office européen des brevets

(11) Publication number: **0 195 576**
**A2**

(12) **EUROPEAN PATENT APPLICATION**

(21) Application number: **86301696.0**

(22) Date of filing: **10.03.86**

(51) Int. Cl.⁴: **H 05 K 7/18**
**F 16 B 43/00**

(30) Priority: **18.03.85 GB 8506926**

(43) Date of publication of application:
**24.09.86 Bulletin 86/39**

(84) Designated Contracting States:
**AT BE CH DE FR GB LI NL SE**

(71) Applicant: **Rittal-Werk Rudolf Loh GmbH & Co. KG**
**Auf dem Stützelberg**
**D-6348 Herborn(DE)**

(72) Inventor: **Keens, Gary**
**6, Beechcroft Close Chandlers Ford**
**Eastleigh SO5 2HU Hampshire(GB)**

(74) Representative: **Purvis, William Michael Cameron et al,**
**D. Young & Co. 10 Staple Inn**
**London WC1V 7RD(GB)**

(54) **Means for mounting a telescopic slide in a rack or cabinet.**

(57) To secure a telescopic slide to an apertured flange (2) of a rack or cabinet without using the caged nuts previously used, a bracket (20) is used, the bracket (20) having opposed flanges (26) which receive the telescopic slide between them and having an end flange (15) with apertures therein preferably formed by a pierce and plunge operation with subsequent screwthreading. Moulded rectangular section members (28) each have a countersunk aperture therein, a rearward portion which engages in an aperture (11) in the flange (2) of the rack or cabinet and a front flange which only projects a small distance (P) forwardly of the front face of the flange (2) of the rack or cabinet. Screws (33) secure the members (28) to the bracket (20) with the flange (2) of the rack or cabinet clamped therebetween.

FIG. 5

EP 0 195 576 A2

1

## MEANS FOR MOUNTING A TELESCOPIC
## SLIDE IN A RACK OR CABINET

The invention relates to means for mounting a telescopic slide in a rack or cabinet.

Racks for electronic components comprise side walls and upper and lower walls, the side walls having inwardly directed flanges, usually referred to as "mounting angles" with apertures punched therein which can be used to mount sub-racks of electronic components. The sub-racks have front plates which are secured to the apertured flanges. Where the sub-racks are such that they may require frequent attention, for example for adjustment or servicing, they may be mounted on telescopic slides such that they can be pulled outwardly and adjusted or serviced while still connected to the rack. A cabinet comprises a rack with the addition of front and rear doors.

Preferably the sub-racks are so mounted on the telescopic slides that they can readily be removed therefrom, for example to lift them onto a bench for more extensive servicing or adjustment.

The apertured flanges of the racks are normally apertured with square shaped apertures of a standard size and a standard pitch, each aperture being able to receive a cage nut, that is to say a screwthreaded square nut in a cage of sheet metal with the cage including ears which can project through the aperture and extend laterally outwardly to retain the cage nut on the rear face, that is to say the inner face, of the apertured flange.

Where a telescopic slide is required to be mounted at one side of a rack, between a flange adjacent the front of the rack and a flange adjacent the rear of the rack, problems arise since it is not possible to provide the cage nuts on the outer faces of the flanges and have screws extending into the cage nuts from brackets provided at the ends of the telescopic sliders since this would cause the cage nuts to project from the outer faces of the flanges and would, at the front, prevent the front plate of the sub-rack lying flush against the outer face of the front flange. To overcome this problem it has been customary to secure two cage nuts on the inner face of the flange in the normal way and to engage a respective screw in each cage nut from the outer face of the flange, the screws having special heads thereon which, when they are fully screwed into the nuts, engage between the ears of the respective cage nut to prevent them moving inwardly and thus becoming disengaged from the flange. Each screw extends completely through the respective cage nut and a bracket at the end of the telescopic slider can be engaged on the inner ends of the screws and secured by nuts engaged on the extreme inner end of the screws. The fixing provided in this way is unsatisfactory in that assembling the bracket and nuts onto the screws is unduly time consuming and the resulting fitting is not very strong and is not rigid, that is to say the cage nuts can still move with respect to the apertured flange.

According to the invention means for mounting a telescopic slide in a rack or cabinet comprises a pair of angled brackets to be secured one to each end of the telescopic slide and each to present a flange to lie adjacent and substantially parallel to a respective front or rear apertured flange of the rack or cabinet, countersunk headed screws, generally rectangular section members with a stepped profile which can engage in and be retained by the apertures in the apertured flanges and which present countersunk holes to receive the countersunk screws and locking means for securing the screws with respect to the flanges of the brackets.

The locking means may comprise screwthreaded apertures in the flanges of the brackets, for example formed by a plunge and pierce operation followed by tapping, or screwthreaded apertures in a locking strip engaged against the inner face of the flange of a respective one of the brackets.

Preferably the generally rectangular section members are formed by moulding a tough plastics material and project only a minimal distance, for example 1mm, outwardly from the outer face of the respective apertured flange in use.

Additional screwthreaded means may be provided on the flanges of the brackets or on the locking strips for engagement by screws projecting through the front plate of a sub-rack mounted on the rack, to maintain the front plate of the sub-rack in juxtaposition with the apertured flanges.

The means for mounting of the invention can provide a sure, safe and rigid mounting of telescopic slides in cabinets. The mounting may be so rigid that difficulties arise due to the manufacturing tolerances of the spacing between the apertured flanges on opposite sides of the rack.

To avoid such difficulties, where each telescopic slide mounts a pair of spaced projections, one at an inner position and defining an outwardly open hook and the other at an outer position and defining an upwardly open hook, the two hooks in use engaging in a recess at an inner end and a recess in the underside of a respective mounting plate fixed to the side of the sub-rack to be mounted, the width of the mouth of at least the upwardly open hook is extended to be a multiple of the thickness of the mounting plate.

The invention is diagrammatically illustrated by way of example in the accompanying drawings, in which:-

Figure 1 is an exploded perspective view showing conventional means for mounting a bracket for a telescopic slide on the apertured flange of a cabinet;

Figures 2a and 2b show an end view and an elevation respectively of a telescopic slide;

Figures 3a, 3b and 3c show various views of a bracket of means for mounting a telescopic slide in a rack or cabinet according to the invention;

Figures 4a, 4b and 4c are respectively a front elevation, rear elevation and sectional view on line IV-IV of a generally rectangular section member of means for mounting a telescopic slide in a rack or cabinet according to the invention;

Figure 5 shows a sectional view through a slide bracket and means securing the bracket to an apertured flange of a rack;

Figure 6 shows an elevation of a plate to be secured to a sub-rack to be mounted on telescopic slides mounted by means for mounting according to the invention; and

Figures 7a, 7b, 8a and 8b show elevations and end views of a pair of spaced projections to be mounted on the telescopic slide and to co-operate with the plate of Figure 6.

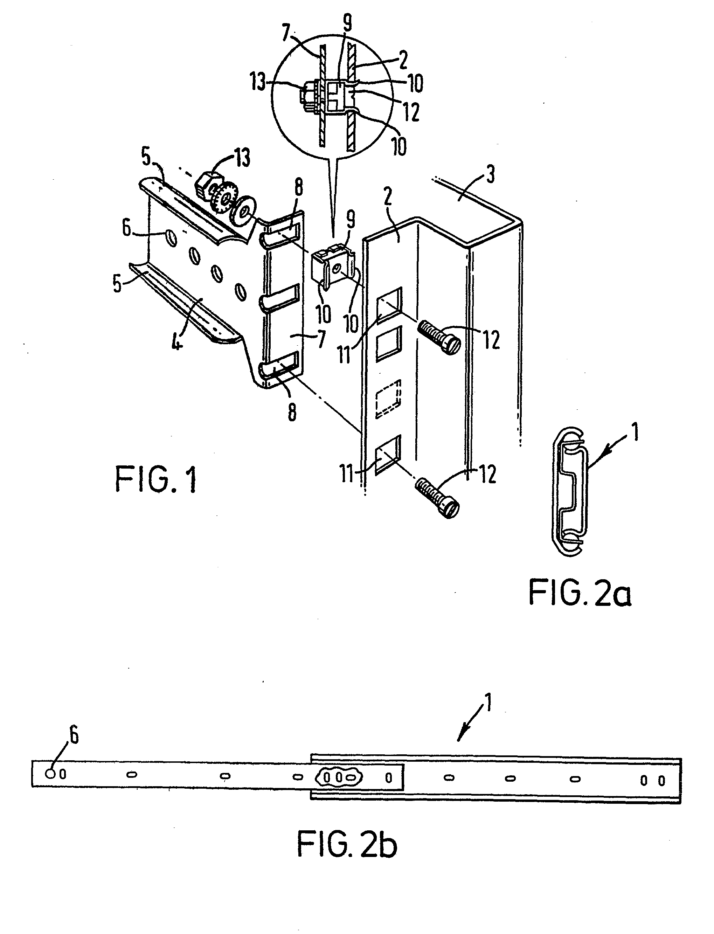

Referring to the drawings and firstly to Figures 1 and 2, a telescopic slider 1, Figures 2a and 2b can be secured at its ends to an apertured flange 2 of a rack 3 by means of a bracket 4 which at one end has a pair of spaced parallel flanges 5 between which the rail 1 is received to be secured by bolts passing through aligned apertures 6 and at the other end has a flange 7 which extends parallel to the apertured flange 2 and has slots 8 therein. Cage nuts 9, only one of which is shown, have ears 10 on the cage and are engaged in apertures 11 in the flange 2 so that the cage nut lies on the inner face of the flange 2 with the ears extending outwardly through the aperture 11 and then laterally. A screw 12 is engaged in the screwthreaded bore in the nut 9 and fully inserted so that the head of the screw 12 extends between the ears 11 and prevents them moving inwardly a distance sufficient to disengage them from the edges of the aperture 11. The inner end of the screw passes through a respective one of the slots 8 in the bracket 4 and is secured by means of washers and a nut 13. An insert in plan view of the assembled arrangement is shown in Figure 1.

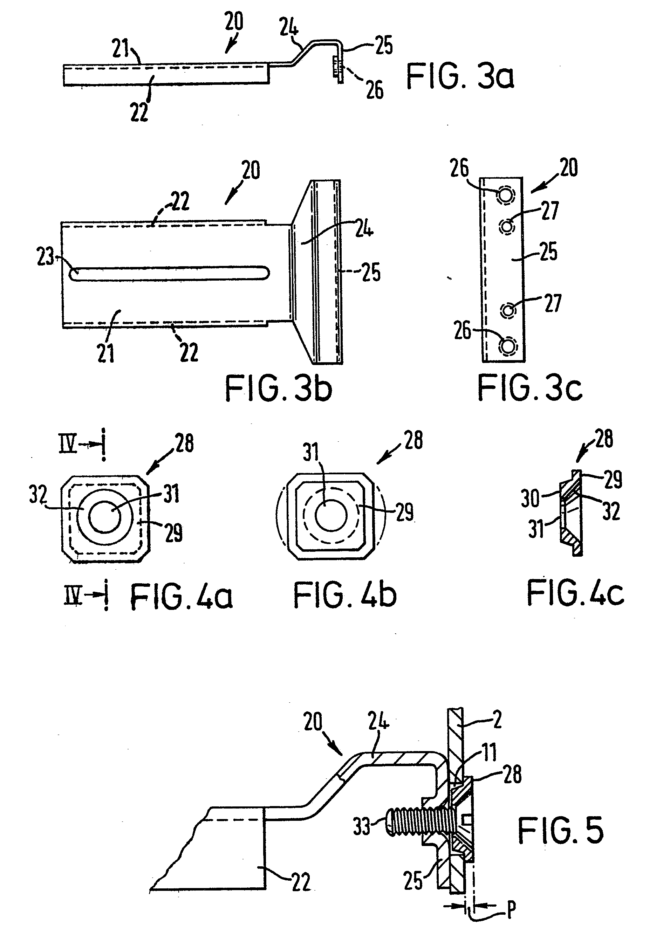

Referring to Figures 3 to 8, a bracket 20 to replace the bracket 4 is shown in Figures 3a, 3b and 3c and comprises a channel shaped end 21 with opposed flanges 22 and with an extended slot 23, a swan necked portion 24 and an end flange 25. The end flange 25 has four apertures therein each formed by a plunge and pierce operation with subsequent screwtapping and comprising advantageously two 6mm screwthreaded apertures 26 and two 4mm screwthreaded apertures 27.

Figures 4a, 4b and 4c show a moulded generally rectangular section member 28 having a front flange 29 and a rearwardly extending portion 30, the rearwardly extending portion 30 being of a maximum size such that it can be engaged within one of the standard apertures 11 in the apertured flange 2 of a rack and the front flange 29 being of a size such that it will not pass through the aperture 11. An aperture 31 is provided in the member 28 with a countersink 32 in the front face, the countersink 32 and the aperture 31 being of a size such that they will receive a 4mm countersunk screw 33 which, as shown in Figure 5, securely clamps the bracket 20 against the inner face of the flange 2. The amount P by which the front face of the flange 29 of the member 28 projects outwardly from the outer face of the flange 2 need not exceed 1mm. If desired the lateral portions of the front flange 29 of the member 28 may be omitted, or the upper flanges could be omitted and the lateral flanges retained, to avoid interference with adjacent components.

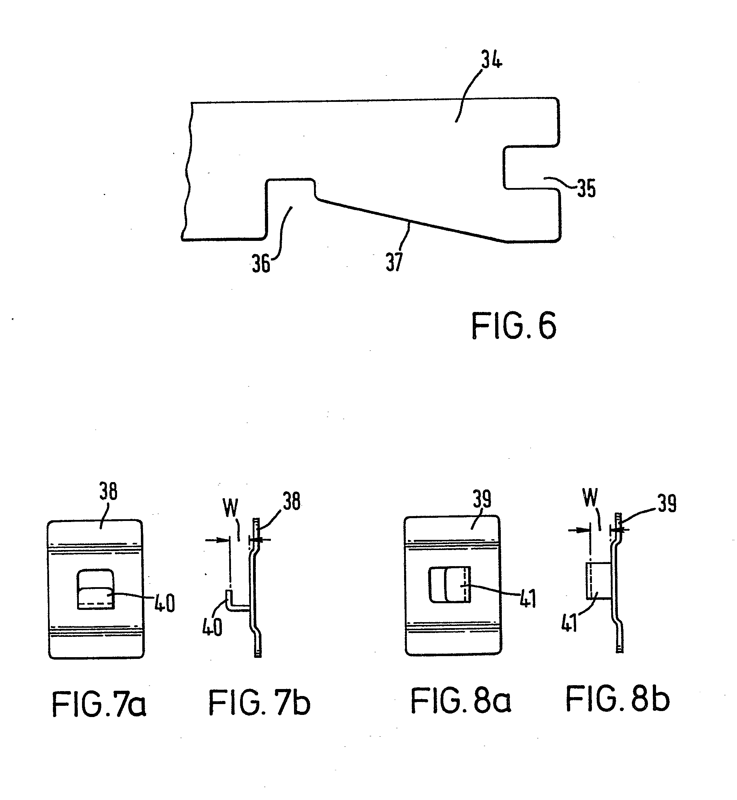

Figure 6 shows a plate to be secured at the side of a sub-rack of equipment and to engage the plate shown in Figures 7a, 7b, 8a and 8b to mount the sub-rack on a telescopic slide.

The plate 34 has a cut-out 35 at its inner end and a cut-out 36 in its underside with a sloped face 37 extending down from the cut-out 36 towards the lower edge adjacent the front end.   An outer bracket 38 is shown in Figures 7a and 7b and an inner bracket 39 is shown in Figures 8a and 8b. The bracket 38 has an outwardly projecting lug 40 which engages in the recess 36 and the bracket 39 has an outwardly extending lug 41 which engages in the recess 35.   The width of the mouth of the lugs 40 and 41, as indicated at W in Figures 7b and 8b, is a multiple of the thickness of the plate 34 such that, after the brackets 38 and 39 have been mounted on the slider, lateral movement of the plate 34 within the lugs 40 and 41 is possible to compensate for tolerances of spacing between the apertured flange 2 and the corresponding apertured flange 2 on the other side of the rack.   The plate 34 is engaged with the lugs 40 and 41 in known manner by slightly raising the outer end of the sub-rack, moving the sub-rack inwardly of the rack to engage the lug 41 in the recess 35 and then lowering the outer end of the sub-rack to engage the lug 40 in the recess 36.

CLAIMS

1.    Means for mounting a telescopic slide (1) in a rack (3) or cabinet comprising a pair of angled brackets (20) to be secured one to each end of the telescopic slide (1) and each to present a flange (25) to lie adjacent and substantially parallel to a respective front or rear apertured flange (2) of the rack (3) or cabinet, countersunk headed screws (33), generally rectangular section members (28) with a stepped profile which can engage in and be retained by the apertures (11) in the apertured flanges (2) and which present countersunk holes (31, 32) to receive the countersunk screws (33) and locking means.(27) for securing the screws with respect to the flanges (25) of the brackets (20).

2.    Means according to claim 1, in which the locking means (27) comprise screwthreaded apertures in the flanges (25) of the brackets (20) formed by a plunge and pierce operation followed by tapping.

3.    Means according to claim 1, in which the locking means (27) comprise screwthreaded apertures in a locking strip engaged against the inner face of the flange (25) of a respective one of the brackets (20).

4.    Means according to any one of claims 1 to 3, in which the generally rectangular section members (28) are formed by moulding a tough plastics material and project only a minimal distance outwardly from the outer face of the respective apertured flange (2) in use.

5.    Means according to claim 3, in which said minimal distance does not exceed 1mm.

6.    Means according to any one of claims 1 to 5, including additional screwthreaded means (26) provided on the flanges (25) of the brackets (20) or on the locking strips for engagement by screws projecting through the front plate of a sub-rack mounted on the rack (3), to maintain the front plate of the sub-rack in juxtaposition with the apertured flanges (2).

7. Means according to any one of claims 1 to 6, in which each telescopic slide mounts a pair of spaced projections (39, 38), one at an inner position and defining an outwardly open hook (41) and the other at an outer position and defining an upwardly open hook (40), the two hooks (41, 40) in use engage in a recess (35) at an inner end and a recess (36) in the underside of a respective mounting plate (34) fixed to the side of the sub-rack to be mounted and the width of the mouth of at least the upwardly open hook (40) is extended to be a multiple of the thickness of the mounting plate (34).

FIG. 1

FIG. 2a

FIG. 2b

0195576

FIG. 3a

FIG. 3b

FIG. 3c

FIG. 4a

FIG. 4b

FIG. 4c

FIG. 5

0195576

FIG.6

FIG.7a  FIG.7b  FIG.8a  FIG.8b